# EUROPEAN PATENT APPLICATION

(11) **EP 1 530 086 A1**
(43) Date of publication of application: **11.05.2005**
(21) Application number: 03078487.0
(22) Date of filing: 05.11.2003
(51) Int. Cl.: G03F 7/20

(54) **A method and an apparatus for producing micro-chips**

(71) Applicant: DSM IP Assets B.V., 6411 TE Heerlen (NL)
(72) Inventor: Jahromi, Shahab, 6216 TE Maastricht (NL); Wienke, Dietrich, 6181 KV Elsloo (NL); Bremer, Leonardus Gerardus Bernardus, 4600 Vise (BE)
(74) Representative: Dorrestijn, Antoon

(57) **Abstract**

Method for producing micro-chips by using immersion lithography, wherein the immersion fluid comprises an additive so that the refractive index of the immersion fluid is increased relative to the fluid not comprising the additive. The exposure light in the method has improved resolution, so that micro-chips having an increased integration density are obtained. The invention also relates to an apparatus for immersion lithography, comprising the immersion fluid.

## Description

The invention relates to a method and an apparatus for producing micro-chips by using immersion lithography.

Since the invention of integrated circuits in 1959, the computing power of microprocessors has been doubled every 18 months and every three years a new generation of micro-chips has been introduced, very time reducing the size of electronic devices. This phenomenon is known as Moore's law. The performance of the micro-chip is, to a large degree, governed by the size of the individual circuit elements in the micro-chip. A micro-chip in general comprises as the circuit elements a complex three-dimensional structure of alternating, patterned layers of conductors, dielectrics, and semiconductor films. As a general rule, the smaller the circuit elements, the faster the micro-chip and the more operations it can perform. This phenomenal rate of increase in the integration density of the micro-chips has been sustained in large by advances in optical lithography which has been the method of choice for producing the micro-chips.

A higher degree of integration of the circuit requires a shorter wavelength of exposure light used in the method of producing micro-chips by optical lithography. Changing of the exposure light to shorter wavelengths, has indeed been the method of choice to increase the resolution. However, switching to shorter wavelengths is becoming increasingly a daunting task as new exposure tools and materials such as photoresists must be designed. This is a difficult enterprise and often results in implementation issues and delays. Therefore chip manufacturers generally tend to postpone the introduction of a new exposure wavelength as long as possible and attempt to prolong the lifetime of an existing technology using alternative approaches. Already for a period of time immersion lithography is considered to be an effective method to improve the resolution limit of a given exposure wavelength. Here the air between the bottom lens and wafer in an exposure tool is replaced with a fluid, see for example: A. Takanashi et al. US Patent No. 4480910 (1984). The fluid should i.a. have a high transparency, it must not influence the chemistry of the photoresists used to produce the micro-chip, it must not degrade the surface of the lens.

Immersion lithography is for example possible for the wavelengths 193 nm and 157 nm. Because of its transparency at 193 nm water is the main candidate for immersion fluid at this wavelength.(See for example: J.H. Burnett, S. Kaplan, Proceedings of SPIE, Vol. 5040, P. 1742 (2003). Because of exceptional transparency of fluorinated and siloxane-based compounds at 157 nm, such fluids are being considered for 157 nm immersion lithography.

Aim of the invention is to provide a method for producing micro-chips by using immersion lithography showing further resolution enhancement.

Surprisingly this aim is achieved because the immersion fluid comprises an additive so that the refractive index of the immersion fluid is higher than the refractive index of the fluid not comprising the additive.

Preferably the refractive index of the immersion fluid is at least 1% higher, more preferably with at least 2%, still more preferably with at least 5%, most preferably at least 10%.

Two types of additives may be added. Additives which are soluble in the base liquid and additives which are insoluble and therefore must therefore be dispersed as (nano)particles in the base liquid. As soluble additives, both organic compounds and liquids, and inorganic (salts) may be used. In case of water as fluid, examples of organic compounds include: various types of sugars, alcohols such as for example cinnamyl alcohol and elthylene glycol, 2-picoline, ethoxy-(ethoxy-ethyl-phosphinothioylsulfanyl)-acetic acid ethyl ester and 1-fluoro-1-(2-hydroxy-phenoxy)-3-methyl-2, 5-dihydro-1 H-1λ5-phosphol-1-ol. Examples of inorganic salts include: mercury monosulphide, mercury(I) bromide, marcasite, calcite, sodium chlorate, lead monoxide, pyrite, lead(II) sulfide, copper(II) oxide, lithium fluoride, tin(IV) sulphide, lithium niobate and lead(II) nitrate. As insoluble compounds in water both inorganic, organic, and metals nanoparticles may be used. The size of the particles are preferably 10 times, more preferable 20 times, and even more preferably 30 times smaller than the corresponding exposure wavelength. The volume percentage of the nanoparticles in the fluid is preferable 10%, more preferably 20%, still even more preferably 30%, even still more preferably 40%. Most preferably the volume percentage is at least 50%, as this results in a fluid having a high reflractive index, a high transparency and low amount of scattering of the incident light. Examples of inorganic and metallic nanoparticles include: Alumina, Aluminum, Aluminum nitride, Aluminum oxide, Antimony pentoxide, Antimony tin oxide, Brass, Calcium carbonate, Calcium chloride, Calcium oxide, Carbon black, Cerium, Cerium oxide, Cobalt, Cobalt oxide, Copper, Copper oxide, Gold, Hastelloy, Hematite- (alpha, beta, amorphous, epsilon, and gamma), Indium, Indium tin oxide, Iron, Iron-cobalt alloy, Iron-nickel alloy, Iron oxide, Iron oxide, transparent, Iron sulphide, Lanthanum, Lead sulphide, Lithium manganese oxide, Lithium titanate, Lithium vanadium oxide, Luminescent, Magnesia, Magnesium, Magnesium oxide, Magnetite, Manganese oxide, Molybdenum, Molybdenum oxide, Montmorillonite clay, Nano oxide suspensions, Nickel, Niobia, Niobium, Niobium oxide, Silicon carbide, Silicon dioxide, Silicon nitride, Silicon nitride, Yttrium oxide, Silicon nitride, Yttrium oxide, Aluminum oxide, Silver, Specialty, Stainless steel, Talc, Tantalum, Tin, Tin oxide, Titania, Titanium, Titanium diboride, Titanium dioxide, Tungsten, Tungsten carbide- cobalt, Tungsten oxide, Vanadium oxide,Yttria, Yttrium, Yttrium oxide, Zinc, Zinc oxide, Zirconium, Zirconium oxide and Zirconium silicate.

It is known to the skilled person how to make stabile dispersions of the nanoparticles in fluids like water.

Suitable commercially available high index water based dispersions of nanoparticles, are for example: NYACOL® ZRO2 (From NYACOL), CELNAX®, SUNCOLLOID® AMT-130S (both from Nissan Chemicals).

The invention also relates to an apparatus for immersion lithography, comprising the immersion fluid.

## Claims

1. Method for producing micro-chips by using immersion lithography, **characterised in that** the immersion fluid comprises an additive so that the refractive index of the immersion fluid is higher than the reflective index of the fluid not comprising the additive.

2. Method for producing micro-chips according to claim 1, **characterised in that** the refractive index is at least 1 % higher.

3. Method according to claim 1 or 2, **characterised in that** the fluid comprises nanoparticles.

4. Method according to claim 3, **characterized in that** the particles have a diameter that is 10 times smaller than the wavelength of the exposure light.

5. Method according to any any of claims 1-4, **characterised in that** the fluid comprises at least 10 volume % of nanoparticles.

6. Method according to any any of claims 1-4, **characterised in that** the fluid comprises at least 50 volume % of nanoparticles.

7. Apparatus for producing micro-chips, based on the technology of immersion lithography, **characterised in that** the apparatus comprises the immersion fluid as defined in any one of claims 1-6.
